# EUROPÄISCHE PATENTSCHRIFT

(11) **EP 1 887 693 B1**
(45) Veröffentlichungstag und Bekanntmachung des Hinweises auf die Patenterteilung: **26.12.2012**
(21) Anmeldenummer: 06016037.1
(22) Anmeldetag: 01.08.2006
(51) Int. Cl.: H03K 17/082, H03K 17/16, H02M 1/08

(54) **System und Verfahren zur Gatespannungsbestimmung eines Leistungsfeldeffekttransistors**
System and method for controlling the gate voltage of a power field effect transistor
Système et procédé de contrôle de la tension de grille d'un transistor de puissance à effet de champ

(43) Veröffentlichungstag der Anmeldung: 13.02.2008
(73) Patentinhaber: SIEMENS AKTIENGESELLSCHAFT, 80333 München (DE)
(72) Erfinder: Klamm, Arnold, 76870 Kandel (DE); Kort, Valentin, 76829 Landau (DE)

(56) Entgegenhaltungen:
- DE-C1- 4 224 243
- US-A- 4 156 837
- SAX H ET AL: "SMART-POWER: VERLUSTARME STEUERUNGS-TREIBER" ELEKTRONIK, WEKA FACHZEITSCHRIFTENVERLAG, POING, DE, Bd. 40, Nr. 7, 2. April 1991 (1991-04-02), Seiten 152,154-156, XP000225181 ISSN: 0013-5658
- LEMME H: "SICHERE SCHALTUNGEN MIT TOPFET. ÖINTELLIGENTER LEISTUNGS-MOSFET MIT SCHUTZFUNKTIONEN" ELEKTRONIK, WEKA FACHZEITSCHRIFTENVERLAG, POING, DE, Bd. 42, Nr. 4, 23. Februar 1993 (1993-02-23), Seiten 24-27, XP000342586 ISSN: 0013-5658

## Beschreibung

Die Erfindung betrifft ein System und ein Verfahren zur Bestimmung einer zwischen Gate und Source eines Leistungsfeldeffekttransistors während des eingeschalteten Zustands des Leistungsfeldeffekttransistors anzulegenden Eingangsspannung gemäß dem Oberbegriff des Anspruchs 1 bzw. 5.

Leistungsfeldeffekttransistoren, insbesondere MOSFET's, werden heute in einer Vielzahl leistungselektronischer Applikationen niedriger und mittlerer Leistung eingesetzt. In Schaltungen für Schaltnetzteile wie beispielsweise Hoch- oder Tiefsetzsteller, Sperr- oder Durchflusswandler, Brückengleichrichter etc. werden Leistungsfeldeffekttransistoren dazu benötigt, aus einer vorgegebenen Eingangsspannung eine für eine zu speisende Last geeignete Ausgangsspannung zu erzeugen. Hierzu wird die Eingangsspannung durch periodisches Ein- und Ausschalten der Leistungsfeldeffekttransistoren in hochfrequente Impulse zerhackt, deren Mittelwert der gewünschten Ausgangsspannung entspricht.

Zum Ein- und Ausschalten der Leistungsfeldeffekttransistoren wird eine Treiberstufe benötigt, die den Steuereingang des Leistungsfeldeffekttransistors, das so genannte Gate, mit annähernd rechteckförmigen Spannungsimpulsen ansteuert. Die Höhe dieser Spannungsimpulse ist nahezu konstant und hängt im Allgemeinen von der Versorgungsspannung der Treiberstufe ab. Ab Erreichen einer gewissen Schwellspannung zwischen Gate- und Sourceeingang des MOSFET's, der so genannten Thresholdspannung, bildet sich zwischen den Anschlüssen Drain und Source ein leitender Kanal mit Majoritätsladungsträgern aus, so dass das Bauelement vollständig einschaltet.

Um unabhängig von den physikalischen Eigenschaften des zu steuernden Leistungsfeldeffekttransistors ein sicheres Durchsteuern im eingeschalteten Zustand zu gewährleisten und somit eine unzulässig hohe Durchlassspannung am Bauelement im leitenden Betrieb zu vermeiden, wird die Treiberspannung mit einem gewissen Sicherheitsabstand zur Thresholdspannung des Leistungsfeldeffekttransistors gewählt.

Der Leistungsfeldeffekttransistor besitzt eine Gatekapazität, die beim Ein- und Ausschalten des Bauelementes umgeladen wird. Hierbei fließt ein Gatestrom, dessen Höhe zum einen von der Gatekapazität des Bauelementes abhängt, zum anderen aber auch von der Höhe der zur Steuerung verwendeten Spannungsimpulse. Durch das periodische Umschalten der Leistungsfeldeffekttransistoren entstehen hierdurch Schaltverluste, die zum einen den Wirkungsgrad der jeweiligen Applikation reduzieren, in die das Bauelement eingebaut ist. Zum anderen muss die durch die Schaltverluste erzeugte Wärme sicher aus dem Bauelement und der Treiberstufe abgeführt werden, wodurch je nach Schaltfrequenz ein nicht unerheblicher Aufwand zur Kühlung des Leistungsfeldeffekttransistors bzw. der Treiberstufe resultiert.

DE 42 24 243 C1 offenbart eine Schaltungsanordnung zur Lastaufschaltung und Lastüberwachung, wobei ein Feldeffekttransistor für den Fall einer niederohmigen Last voll und für den Fall einer hochohmigen Last nicht voll durchschaltet.

Ein System gemäß dem Oberbegriff des Anspruchs 1 ist aus dem Fachaufsatz von Herbert Sax und Michael Barou mit dem Titel "Smart-Power: verlustarme Steuerungs-Treiber", Fachmagazin ELEKTRONIK, WEKA Fachzeitschriftenverlag, Poing, DE, Bd. 40, Nr. 7, 2. April 1991 (1991-04-02), Seiten 152, 154-156, XP000225181 ISSN: 0013-5658 bekannt.

Der Erfindung liegt die Aufgabe zugrunde, in einem System sowie bei einem Verfahren der eingangs genannten Art möglichst geringe Verluste bei einem Betrieb eines Leistungsfeldeffekttransistors zu ermöglichen.

Diese Aufgabe wird im Hinblick auf das System durch die im kennzeichnenden Teil des Anspruchs 1 angegebenen, bezüglich des Verfahrens durch die im kennzeichnenden Teil des Anspruchs 5 angegebenen Maßnahmen gelöst.

Der Erfindung liegt die Erkenntnis zugrunde, dass sich die Verluste des Leistungsfeldeffekttransistors unter Berücksichtigung der Durchlass, Schalt- und Ansteuerverluste deutlich reduzieren lassen, wenn die im eingeschalteten Zustand am Gate des Leistungsfeldeffekttransistors anliegende Einschaltspannung variabel und abhängig von der Durchlassspannung des Bauteils gewählt werden kann. Soll beispielsweise nur ein sehr kleiner Strom von dem Leistungsfeldeffekttransistor im eingeschalteten Zustand geführt werden, so ist es im Sinne des Gesamtwirkungsgrades nicht sinnvoll, die Gatekapazität voll aufzuladen. Insbesondere bei einer hohen Schaltfrequenz dominieren dann die Ansteuerverluste, die durch das Umladen des Gates hervorgerufen werden, gegenüber den Durchlassverlusten im eingeschalteten Zustand des Leistungsfeldeffekttransistors. In diesem Fall ist eine Reduzierung der Gatespannung und damit der Umladungsverluste auf Kosten der Durchlassverluste sinnvoll.

Das System ist zur Verwendung innerhalb eines Schaltnetzteils vorgesehen. Heutige Schaltnetzteile arbeiten teilweise mit Frequenzen im Megahertzbereich, bei denen die Ansteuerungsverluste eine erhebliche Rolle spielen. Aufgrund der gewaltigen Anzahl von Schaltnetzteilen, die heutzutage sowohl im haushaltsnahen Bereich als auch bei industriellen Anwendungen eingesetzt werden, ist hier einer Optimierung des Gesamtwirkungsgrades eine sehr hohe Bedeutung beizumessen.

Der Vorteil der Überwachung und Regelung der Durchlassspannung am Leistungsfeldeffekttransistor, der Drain-Source-Spannung, ist zum einen, dass die Gesamtverluste des Bauelementes lastabhängig optimiert werden können. Darüber hinaus können aber auch Exemplarstreuungen bei Leistungsfeldeffekttransistoren ausgeglichen werden. Beispielsweise führen unterschiedliche physikalische Eigenschaften von in einer Schaltung verwendbaren Leistungsfeldeffekttransistoren dazu, dass die unterschiedlichen Bauteile bei unterschiedlichen Gate-Source-Spannungen voll durchsteuern. Mit Hilfe des erfindungsgemäßen Systems kann eine derartige Exemplarsteuerung berücksichtigt werden, so dass diese unterschiedlichen Bauteile auch mit unterschiedlichen Gatespannungen angesteuert werden und so jeweils einen optimalen Gesamtwirkungsgrad erreichen.

Das System weist Mittel zur Bestimmung des Referenzwertes in Abhängigkeit eines vom Leistungsfeldeffekttransistor zu leitenden Stromes auf derart, dass die Summe aus den Ansteuerungsverlusten und den Durchlassverlusten des Leistungsfeldeffekttransistors minimiert wird. Beispielsweise umfassen die Mittel einen Mikrocontroller, mit dessen Hilfe ein lastabhängiges Optimum bezüglich der Verteilung von Durchlassverlusten und Ansteuerungsverlusten auf die Gesamtverlustleistung des Leistungsfeldeffekttransistors bestimmt wird.

In einer vorteilhaften Ausgestaltung der Erfindung ist der Regler zur Bestimmung der Versorgungsspannung eines Gatetreibers des Leistungsfeldeffekttransistors vorgesehen. Die Versorgungsspannung des Gatetreibers hat direkten Einfluss auf die im eingeschalteten Zustand des Leistungsfeldeffekttransistors am Gate anliegende Steuerspannung.

In einer weiteren Ausgestaltung der Erfindung ist der Leistungsfeldeffekttransistor als MOSFET oder JFET ausgeführt. Sowohl MOSFET als auch JFET besitzen im voll ausgesteuerten Bereich eine nahezu lineare Stromspannungskennlinie. Es handelt sich um unipolare Bauelemente, bei denen eine Ausführung der erfindungsgemäßen Durchlassspannungsregelung sehr gut angewendet werden kann.

Eine vorteilhafte Ausführungsform der Erfindung ist dadurch gekennzeichnet, dass die Messeinrichtung einen Komparator und der Regler einen Transistor aufweist, an dessen Steuereingang eine vom Ausgang des Komparators abhängige Steuerspannung anliegt. Der Komparator vergleicht den Wert der aktuellen Durchlassspannung mit dem Wert der Referenzspannung und erzeugt ein entsprechendes Ausgangssignal, welches wiederum den Transistor ansteuert, der seinerseits direkten Einfluss auf die Höhe der Gate-Source-Spannung hat.

Üblicherweise wird zwischen dem Gateeingang des Leistungsfeldeffekttransistors und der hiermit verbundenen Treiberstufe ein Gatevorwiderstand verwendet, um die Steilheit der Schaltflanke der Gate-Source-Spannung zu reduzieren. Dies wird im Allgemeinen aus Gründen der elektromagnetischen Verträglichkeit vorgesehen. In vorteilhafter Ausgestaltung der Erfindung kann auf einen solchen Gatevorwiderstand verzichtet werden, indem der Regler zur Begrenzung eines beim Einschalten des Leistungsfeldeffekttransistors fließenden Einschaltstromes vorgesehen ist.

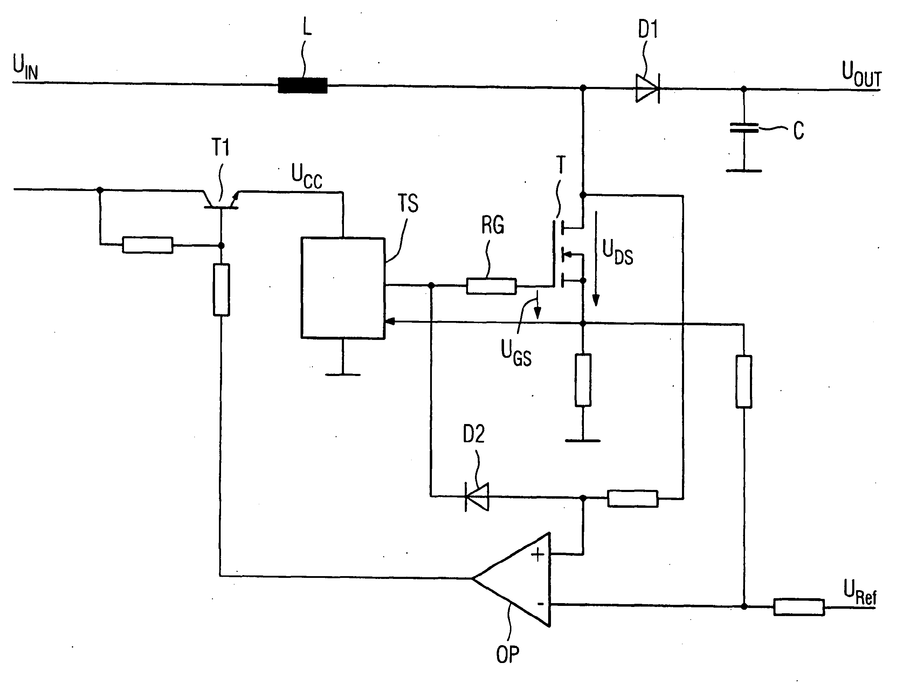

Im Folgenden wird die Erfindung anhand des in der Figur dargestellten Ausführungsbeispiels näher beschrieben und erläutert.

Die Figur zeigt einen Schaltplan eines als Hochsetzsteller ausgeführten Schaltnetzteiles mit einem Leistungsfeldeffekttransistor T, dessen Durchlassspannung U_{DS} geregelt wird.

Der Leistungsfeldeffekttransistor T ist als n-kanal Leistungs-MOSFET ausgeführt.

Ziel der dargestellten Schaltung ist es, eine Eingangsspannung U_{IN} in eine höhere Ausgangsspannung U_{OUT} umzuwandeln, über die ein an das Schaltnetzteil anzuschließender Verbraucher gespeist wird. Im eingeschalteten Zustand des MOSFET's T wird über eine Glättungsinduktivität L ein Strom aufgebaut, der nach Abschalten des MOSFET's T in der so genannten "Boostphase" über eine Diode D1 einen Glättungskondensator C lädt. Der MOSFET T wird mit dem so genannten Dutycycle periodisch getaktet. Abhängig von diesem Dutycycle, der das Verhältnis der Einschaltdauer des MOSFET's T zur Schaltperiode angibt, stellt sich die Ausgangsspannung U_{OUT} am Ausgang des Schaltnetzteiles ein.

Im eingeschalteten Zustand des MOSFET's T wird die Durchlassspannung U_{DS} auf einen Eingang eines Komparators OP gegeben, der diese mit einem Referenzwert U_{Ref} einer an einem anderen Eingang des Komparators OP anliegenden Referenzspannung vergleicht. Übersteigt die Durchlassspannung U_{DS} den Referenzwert U_{Ref}, so wird über den Ausgang des Komparators OP die Basis eines bipolaren Transistors T1 weiter aufgesteuert, wodurch die Versorgungsspannung eines Gatetreibers TS des Leistungs-MOSFET's T mit einer höheren Spannung versorgt wird. In der Folge wird auch die von der Treiberstufe TS erzeugte Gate-Source-Spannung U_{GS} weiter erhöht, wodurch schließlich die Durchlassspannung U_{DS} des Transistors T reduziert wird, bis sie schließlich unterhalb des Referenzwertes U_{Ref} liegt.

Auf diese Art und Weise kann ein Optimum für den Gesamtwirkungsgrad des dargestellten Schaltnetzteiles eingestellt werden, indem durch eine geeignete Wahl der Durchlassspannung U_{DS} und der damit bewusst in Kauf genommenen Durchlassverluste eine Reduzierung der Ansteuerungsverluste des MOSFET'S T erzielt wird.

Zwischen dem Gatetreiber TS und dem MOSFET T ist ein Gatewiderstand RG eingezeichnet, auf den jedoch aufgrund der ohnehin schon vorhandenen Begrenzung der Steilheit der Schaltflanke des MOSFET's T auch verzichtet werden könnte.

Um sicherzustellen, dass die Drain-Source-Spannung U_{DS} des MOSFET's T nur im eingeschalteten Zustand des MOSFET's T am Eingang des Komparators OP anliegt, ist in einem Verbindungszweig zwischen Drain und Gate des MOSFET's T eine weitere Diode D2 vorgesehen.

Der dargestellte Komparator OP kann auch als Hystereseregler ausgeführt werden, der die Durchlassspannung U_{DS} des MOSFET's T innerhalb eines um den Referenzwert U_{Ref} liegenden Toleranzbandes einregelt. Berührt die Durchlassspannung die obere Grenze des Toleranzbandes, so wird die Versorgungsspannung U_{CC} des Gatetreibers TS erhöht, um die Durchlassverluste des MOSFET's zu reduzieren. Berührt die Drain-Source-Spannung U_{DS} hingegen die untere Grenze des Toleranzbandes, so wird die Versorgungsspannung U_{CC} verringert, um die Ansteuerungsverluste zu reduzieren.

## Patentansprüche

1. System zur Bestimmung einer zwischen Gate und Source eines Leistungsfeldeffekttransistors (T) während des eingeschalteten Zustands des Leistungsfeldeffekttransistors (T) anzulegenden Einschaltspannung (U_{GS}) mit
- einer Messeinrichtung zur Messung der Durchlassspannung (U_{DS}) des Leistungsfeldeffekttransistors (T) im eingeschalteten Zustand und zum Vergleich der Durchlassspannung (U_{DS}) mit einem Referenzwert (U_{Ref}) und
- einem Regler zur Bestimmung der Einschaltspannung (U_{GS}) in Abhängigkeit des Ergebnisses besagten Vergleiches, wobei der Regler zur Begrenzung der Durchlassspannung (U_{DS}) auf den Referenzwert (U_{Ref}) als oberer Grenzwert vorgesehen ist,
**dadurch gekennzeichnet, dass** das System zur Verwendung innerhalb eines Schaltnetzteils vorgesehen ist und Mittel zur Bestimmung des Referenzwertes (U_{Ref}) in Abhängigkeit eines vom Leistungsfeldeffekttransistor (T) zu leitenden Stromes aufweist derart, dass die Summe aus den Ansteuerungsverlusten und den Durchlassverlusten des Leistungsfeldeffekttransistors (T) minimiert wird.

2. System nach Anspruch 1,
**dadurch gekennzeichnet, dass** der Regler zur Bestimmung der Versorgungsspannung (U_{CC}) eines Gatetreibers (TS) des Leistungsfeldeffekttransistors (T) vorgesehen ist.

3. System nach Anspruch 1 oder 2,
**dadurch gekennzeichnet, dass** der Leistungsfeldeffekttransistor (T) als MOSFET oder JFET ausgeführt ist.

4. System nach einem der vorhergehenden Ansprüche,
wobei die Messeinrichtung einen Komparator (OP) und der Regler einen Transistor (T1) aufweist, an dessen Steuereingang eine vom Ausgang des Komparators (OP) abhängige Steuerspannung anliegt.

5. System nach einem der vorhergehenden Ansprüche,
wobei der Regler zur Begrenzung eines beim Einschalten des Leistungsfeldeffekttransistors (T) fließenden Einschaltstromes vorgesehen ist.

6. Verfahren zur Bestimmung einer zwischen Gate und Source eines Leistungsfeldeffekttransistors (T) während des eingeschalteten Zustands des Leistungsfeldeffekttransistors (T) anzulegenden Einschaltspannung (U_{GS}) mit folgenden Verfahrensschritten:
- Messen der Durchlassspannung (U_{DS}) des Leistungsfeldeffekttransistors (T) im eingeschalteten Zustand,
- Vergleichen der Durchlassspannung (U_{DS}) mit einem Referenzwert (U_{Ref}) und
- Bestimmen der Einschaltspannung (U_{GS}) in Abhängigkeit des Ergebnisses besagten Vergleiches mittels eines Reglers, wobei die Durchlassspannung (U_{DS}) mit dem Regler auf den Referenzwert (U_{Ref}) als oberen Grenzwert begrenzt wird,
**dadurch gekennzeichnet, dass** das Verfahren zur Bestimmung der Einschaltspannung bei einem in einem Schaltnetzteil eingebauten Leistungsfeldeffekttransistor (T) durchgeführt wird und dass der Referenzwert (U_{Ref}) in Abhängigkeit eines vom Leistungsfeldeffekttransistor (T) zu leitenden Stromes bestimmt wird, derart, dass die Summe aus den Ansteuerungsverlusten und den Durchlassverlusten des Leistungsfeldeffekttransistors (T) minimiert wird.

7. Verfahren nach Anspruch 6,
**dadurch gekennzeichnet, dass** die Versorgungsspannung (U_{CC}) eines Gatetreibers (TS) des Leistungsfeldeffekttransistors (T) mit dem Regler bestimmt wird.

8. Verfahren nach Anspruch 7,
wobei der Leistungsfeldeffekttransistor (T) als MOSFET oder JFET ausgeführt ist.

9. Verfahren nach einem der Ansprüche 6 bis 8,
**dadurch gekennzeichnet, dass** die Durchlassspannung (U_{DS}) mittels eines Komparators (OP) mit dem Referenzwert (U_{Ref}) verglichen wird und eine vom Ausgang des Komparators (OP) abhängige Steuerspannung an den Steuereingang eines Transistors (T1) gelegt wird.

10. Verfahren nach einem der Ansprüche 6 bis 9,
**dadurch gekennzeichnet, dass** ein beim Einschalten des Leistungsfeldeffekttransistors (T) fließender Einschaltstrom mit dem Regler begrenzt wird.

## Claims

1. System for determining a switch-on voltage (U_{GS}) to be applied between gate and source of a power field effect transistor (T) during the switched-on state of the power field effect transistor (T), comprising
- a measuring device for measuring the forward voltage (U_{DS}) of the power field effect transistor (T) in the switched-on state and for comparing the forward voltage (U_{DS}) with a reference value (U_{Ref}), and
- a controller for determining the switch-on voltage (U_{GS}) depending on the result of said comparison, wherein the controller is provided for limiting the forward voltage (U_{DS}) to the reference value (U_{Ref}) as upper limit value,
**characterized in that** the system is provided for use within a switched-node power supply and comprises means for determining the reference value (U_{Ref}) depending on a current to be conducted by the power field effect transistor (T), in such a way that the sum of the driving losses and the on-state losses of the power field effect transistor (T) is minimized.

2. System according to Claim 1,
**characterized in that** the controller is provided for determining the supply voltage (U_{CC}) of a gate driver (TS) of the power field effect transistor (T).

3. System according to Claim 1 or 2,
**characterized in that** the power field effect transistor (T) is embodied as MOSFET or JFET.

4. System according to any of the preceding claims,
wherein the measuring device has a comparator (OP) and the controller has a transistor (T1), at the control input of which a control voltage dependent on the output of the comparator (OP) is present.

5. System according to any of the preceding claims,
wherein the controller is provided for limiting a switch-on current flowing when the power field effect transistor (T) is switched on.

6. Method for determining a switch-on voltage (U_{GS}) to be applied between gate and source of a power field effect transistor (T) during the switched-on state of the power field effect transistor (T), comprising the following method steps:
- measuring the forward voltage (U_{DS}) of the power field effect transistor (T) in the switched-on state,
- comparing the forward voltage (U_{DS}) with a reference value (U_{Ref}), and
- determining the switch-on voltage (U_{GS}) depending on the result of said comparison by means of a controller, wherein the forward voltage (U_{DS}) is limited to the reference value (U_{Ref}) as upper limit value by the controller,
**characterized in that** the method for determining the switch-on voltage is carried out in the case of a power field effect transistor (T) incorporated in a switched-node power supply, and **in that** the reference value (U_{Ref}) is determined depending on a current to be conducted by the power field effect transistor (T), in such a way that the sum of the driving losses and the on-state losses of the power field effect transistor (T) is minimized.

7. Method according to Claim 6,
**characterized in that** the supply voltage (U_{CC}) of a gate driver (TS) of the power field effect transistor (T) is determined by the controller.

8. Method according to Claim 7,
wherein the power field effect transistor (T) is embodied as MOSFET or JFET.

9. Method according to any of Claims 6 to 8,
**characterized in that** the forward voltage (U_{DS}) is compared with the reference value (U_{Ref}) by means of a comparator (OP) and a control voltage dependent on the output of the comparator (OP) is applied to the control input of a transistor (T1).

10. Method according to any of Claims 6 to 9,
**characterized in that** a switch-on current that flows when the power field effect transistor (T) is switched on is limited by the controller.

## Revendications

1. Système de détermination d'une tension (U_{GS}) de seuil s'appliquant entre la grille et la source d'un transistor ( T ) à effet de champ de puissance pendant l'état passant du transistor ( T ) à effet de champ de puissance, comprenant
- un dispositif de mesure pour la mesure de la tension ( U_{DS} ) à l'état passant du transistor ( T ) à effet de champ de puissance à l'état passant et pour la comparaison de la tension ( UDS ) à l'état passant à une valeur ( U_{ref} ) de référence et
- un régulateur de détermination de la tension ( U_{GS} ) de seuil en fonction du résultat de ladite comparaison, le régulateur étant prévu pour la limitation de la tension ( U_{DS} ) à l'état passant à la valeur ( U_{ref} ) de référence comme valeur limite supérieure,
**caractérisé en ce que** le système est prévu pour être utilisé dans une alimentation à découpage et a des moyens de détermination de la valeur ( U_{ref} ) de référence, en fonction d'un courant à faire passer par le transistor ( T ) à effet de champ de puissance, de manière à minimiser la somme des pertes de commande et des pertes à l'état passant du transistor ( T ) à effet de champ de puissance.

2. Système suivant la revendication 1,
**caractérisé en ce que** le régulateur est prévu pour la détermination de la tension ( U_{CC} ) d'alimentation d'un attaqueur ( TS ) de grille du transistor ( T ) à effet de champ de puissance.

3. Système suivant la revendication 1 ou 2,
**caractérisé en ce que** le transistor ( T ) à effet de champ de puissance est réalisé en MOSFET ou en JFET.

4. Système suivant l'une des revendications précédentes, **caractérisé en ce que** le dispositif de mesure a un comparateur ( OP ) et le régulateur a un transistor ( T1 ), à l'entrée de commande duquel s'applique une tension de commande qui dépend de la sortie du comparateur ( OP ).

5. Système suivant l'une des revendications précédentes,
dans lequel le régulateur est prévu pour la limitation d'un courant de seuil passant, lorsque le transistor ( T ) à effet de champ de puissance est à l'état passant.

6. Procédé de détermination d'une tension ( U_{GS} ) à l'état passant du transistor ( T ) à effet de champ de puissance à l'état passant et pour la comparaison de la tension ( U_{DS} ) à l'état passant à une valeur ( U_{ref} ) de référence ayant les stades de procédé suivants :
- on mesure la tension ( U_{DS} ) à l'état passant du transistor ( T ) à effet de champ de puissance à l'état passant,
- on compare la tension ( U_{DS} ) à l'état passant à une valeur ( U_{ref} ) de référence et
- on détermine la tension ( U_{GS} ) de seuil en fonction du résultat de ladite comparaison au moyen d'un régulateur, la tension ( U_{DS} ) à l'état passant étant limitée par le régulateur à la valeur ( U_{ref} ) de référence comme valeur limite supérieure,
**caractérisé en ce qu'**on effectue le procédé de détermination de la tension de seuil pour un transistor ( T ) à effet de champ de puissance incorporé dans une alimentation à découpage et **en ce que** l'on détermine la valeur ( U_{ref} ) de référence en fonction d'un courant à faire passer par le transistor ( T ) à effet de champ de puissance, de manière à minimiser la somme des pertes de commande et des pertes à l'état passant du transistor ( T ) à effet de champ de puissance.

7. Procédé suivant la revendication 6,
**caractérisé en ce que** l'on détermine la tension ( U_{cc} ) d'alimentation d'un attaqueur ( TS ) de grille du transistor ( T ) à effet de champ de puissance par le régulateur.

8. Procédé suivant la revendication 7,
dans lequel le transistor ( T ) à effet de champ de puissance est réalisé en MOSFET ou en JFET.

9. Procédé suivant l'une des revendications 6 à 8,
**caractérisé en ce que** l'on compare la tension ( U_{DS} ) à l'état passant au moyen d'un comparateur ( OP ) à la valeur ( U_{ref} ) de référence et on applique à l'entrée de commande d'un transistor ( T1 ) une tension de commande qui dépend de la sortie du comparateur ( OP ).

10. Procédé suivant l'une des revendications 6 à 9,
**caractérisé en ce qu'**un courant de seuil passant, lorsque le transistor ( T ) à effet de champ de puissance est à l'état passant, est limité par le régulateur.
